# EUROPEAN PATENT APPLICATION

(11) **EP 4 553 884 A1**
(43) Date of publication of application: **14.05.2025**
(21) Application number: 24210105.3
(22) Date of filing: 31.10.2024
(51) Int. Cl.: H01J 37/04, H01J 37/147, H01J 37/30

(54) **MINIMIZATION OF COULOMB INTERACTIONS AND ENERGY SPREAD IN FOCUSED ION BEAM (FIB) SYSTEMS**

(30) Priority: 10.11.2023 US 202318506957
(71) Applicant: FEI Company, Hillsboro, OR 97124 (US)
(72) Inventor: VASINA, Radovan, Brno (CZ); SED'A, Bohuslav, Brno (CZ); MAAZOUZ, Mostafa, Portland (US); KRÁL, Lukás, Brno (CZ)
(74) Representative: Boult Wade Tennant LLP

(57) **Abstract**

Charged-particle beam (CPB) optical systems can include a beam acceptance aperture plate defining a first acceptance aperture and at least one second acceptance aperture, situated with respect to a CPB source so that a first CPB is transmitted by the first acceptance aperture and a second CPB is transmitted by a second acceptance aperture. A CPB lens is situated to receive the first and second CPBs from the beam acceptance aperture plate and direct the first and second CPBs towards a filter aperture plate to transmit selected spectral portion of the second CPB. The selected spectral component of the first CPB can be selectively directed to a workpiece by a beam steering deflector along the same axis. In some examples, the first and second CPBs have different beam currents and only one is directed to a workpiece.

## Description

### FIELD

The disclosure pertains to ion beam systems and ion beam processing.

### BACKGROUND

Focused ion beam devices (FIB) represent an important tool of semiconductor, material science, and life science workflows. FIBs can be used for sputtering of large volumes of material or fine machining on a nanometer scale. FIB brightness and energy spread are important considerations in determining FIB spot size. Coulomb interactions are another important limiting factor in determining FIB spot size. While Coulomb interactions can be suppressed by limiting beam current, many FIB applications require substantial beam current and limiting beam current is not practical. In one prior art approach described in U.S. Patent 7,034,315, which is incorporated herein by reference, a beam-limiting diaphragm is used in conjunction with energy dispersion produced by chromatic aberration is to produce a central beam with a large current and an eccentric beam with reduced current. However, improved approaches that can provide charged-particle beams (CPBs) with variable beam currents and variable energy spreads are needed.

### SUMMARY

CPB systems and methods permit delivery of CPBs based on selected portions of an emitted CPB as well as selected energy spreads. In typical examples, an axial CPB and an off-axis CPB are created with an extractor aperture plate that defines corresponding apertures. The off-axis CPB is chromatically dispersed and a filter aperture is used to select a portion of the chromatically dispersed, off-axis CPB to produce a CPB with a selected spectrum or energy spread. Typically, the spectrum of the CPB is selected by limiting the chromatically spread CPB at an aperture edge. A beam steering deflector is situated optically downstream of the filter aperture and is operable to direct the spectrally selected, off-axis CPB portion to a workpiece along an axis associated with propagation of the axial CPB. In most cases, the axial CPB is a relatively high current CPB without substantial limiting of energy spread. The off-axis CPB generally has a relatively smaller beam current with a limited energy spread. A filtering deflector is operable to select which portion of the chromatically spread, off-axis is transmitted by a filter aperture and thus permits selection of off-axis CPB energy spread. One or both of the on-axis and off-axis beams can have circular or elliptical or other shapes. Elliptical or line shapes in which CPBs are spread over larger areas can reduce current density and thus reduce sputtering or other damage to an aperture edge.

The foregoing features and advantages of the disclosed technology will become more apparent from the following detailed description, which proceeds with reference to the accompanying figures.

### BRIEF DESCRIPTION OF THE DRAWINGS

FIG. 1A illustrates a representative charged-particle beam (CPB) system that can provide CPBs with different currents and energy spreads showing an off-axis CPB directed toward a workpiece.
FIG. 1B illustrates the CPB system that of FIG. 1A showing an axial CPB directed toward the workpiece.
FIG. 1C is a sectional view of FIG. 1A illustrating CPB positions at a filter aperture that transmits an axial CPB and an off-axis CPB having a predetermined spectrum.
FIGS. 1D-1E are sectional views of FIG. 1A and FIG. 1B, respectively, illustrating CPB positions at a filter aperture that transmits an off-axis CPB having a predetermined spectrum (FIG. 1A) and an axial CPB (FIG. 1B).
FIG. 1F is a sectional view at a filter aperture plate that can be used as an alternative to the filter aperture plate of FIGS. 1A-1B.
FIG. 2 illustrates a representative method of producing multiple CPBs and delivering a selected CPB with a selected spectral spread to a workpiece.
FIG. 3 illustrates a CPB system operable to provide CPBs with selectable beam currents and energy spreads.
FIGS. 4A-4B illustrate representative acceptance apertures.
FIG. 5A-5B illustrate a CPB system that produces an axial CPB and an off-axis CPB either of which can be delivered to a workpiece along a common axis.
FIG. 6 illustrates a CPB system that produces an axial CPB and an off-axis CPB either of which can be delivered to a workpiece along an axis.
FIG. 7 illustrates a portion of the CPB system such as that of FIG. 6 having a beam acceptance aperture plate that defines a plurality of beam acceptance apertures.
FIG. 8 illustrates a representative method of producing multiple CPBs and delivering a selected CPB to a workpiece to, for example, select a CPB current.

### DETAILED DESCRIPTION

Systems, methods, and apparatus that permit selective delivery of charged-particle beams (CPBs) with various currents and energy spreads are disclosed. In the examples, two or more CPBs are established, typically a first CPB having a relatively high beam current and with a wide energy range and a second having a lower beam current with a narrow energy range. With the disclosed approaches, one or more CPBs with selected different beam currents and energy ranges can be provided.

### General Terminology

As used herein, "optical column" refers to a system of one or more CPB optical elements such as electrostatic lenses, magnetic lenses, apertures, stigmators, deflectors, scanners, and CPB sources such as electron or ion emitters. For convenient description, apertures are referred to as being defined in aperture plates, and as used herein, "aperture plate" refers to any material that is used to define an aperture, whether shaped as a plate, some other shape, or as a portion of one or more CPB optical elements. Spectral component or CPB spectral component refers to a CPB having a selected energy range. CPB beam cross-sections can be symmetric or asymmetric and, in the examples, described herein, elliptical, or other elongated beam shapes can be used. Apertures used in controlling and shaping CPBs can be symmetric or asymmetric such as elliptical or otherwise elongated, and in some cases, an aperture is defined by a single edge that can be linear or curved and situated so that a CPB interacts solely or primarily with this single edge. In some examples, a higher current CPB without or with limited spectral or energy filtering can propagate along an optical axis to a workpiece without deflection and a lower current CPB propagates off-axis and reach the workpiece after one or more deflections. However, optical columns can be arranged so that either or both of these CPBs require deflection to be directed to a workpiece. For convenience, any substrate to which one or more CPBs are directed for processing, imaging, or other purposes is referred to as a workpiece, even in situations in which the one or more CPBs are used for imaging only. The examples are generally illustrated with CPBs that are normally incident to workpieces for convenient illustration, but any angles of incidence can be used. In some examples, aperture plates are referred to as blanking aperture plates and are associated with blocking or attenuating one or more CPBs.

As used herein, energy spread, energy range, and spectral width refer to a range of charged-particle energies associated with a CPB. Filtering refers to reducing or otherwise limiting an energy spread, energy range of a CPB and/or selecting a particular energy spread or spectral component.

In the examples, CPB propagation directions are illustrated as varied using beam deflectors which generally do not provide CPB focusing or defocusing and CPB lenses which can alter beam propagation directions and provide CPB focusing or defocusing. As used herein, beam selector or beam selector system includes one or more CPB lenses or beam deflectors. In addition, CPB lenses are used in the examples to provide spectral dispersion of CPB beams based on chromatic aberration, but other CPB optical elements can be used to do so. As used herein, a CPB spectral disperser includes one or more CPB lenses and/or other spectrally dispersive CPB optics.

CPBs are typically defined using a CPB source and one or more apertures, referred to herein generally as beam acceptance apertures. In typical examples based on focusing ion beams (FIBs), these beam acceptance apertures and associated beam acceptance aperture plates serve to extract CPBs and can alternatively be referred to as extractor apertures and extractor aperture plates.

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatuses are referred to as "lowest", "best", "minimum," or the like. It will be appreciated that such descriptions are intended to indicate that a selection among many used functional alternatives can be made, and such selections need not be better, smaller, or otherwise preferable to other selections.

### Example 1

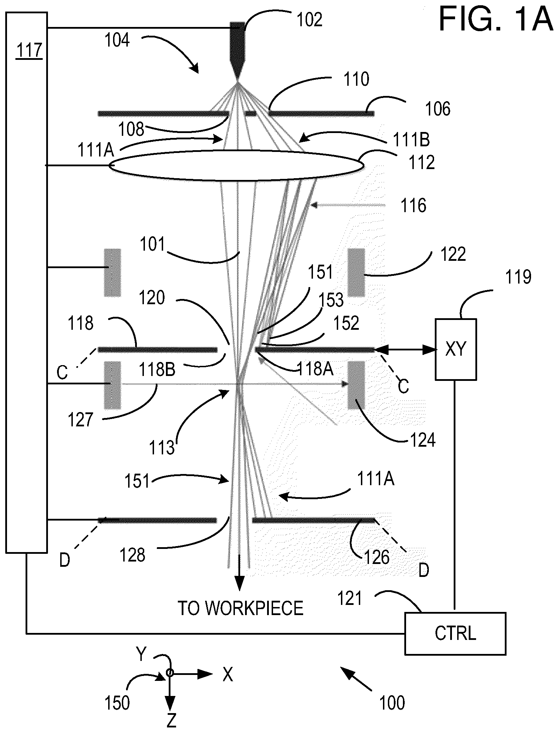

With reference to FIG. 1A, a portion of a charged-particle-beam (CPB) optical system 100 includes a CPB emitter 102 that is situated to direct a CPB 104 to a beam acceptance aperture plate 106. The beam acceptance aperture plate 106 defines a first aperture 108 (typically along an axis 101 of the CPB optical system 100) and a second aperture 110 (typically an off-axis aperture) that define an axial CPB 111A and an off-axis CPB 111B, respectively, as well as blocking or otherwise attenuating some portions of the CPB from the CPB emitter 102. The CPB 111A can be referred to as an axial CPB as it propagates from the CPB source 102 through the first aperture 108 along the axis 101. The CPB 111B can be referred to as an off-axis CPB as it propagates from the CPB source 102 through the second aperture 110 at an angle to the axis 101.

The axial CPB 111A is directed along the axis 101 to a lens 112 that is operable focus the axial CPB 111A along the axis 101 to a crossover 113 and through to a filter aperture 120 in a filter aperture plate 118. The CPB 111A is generally associated with a substantially higher beam current than that of the CPB 111B. The aperture 120 is bounded by respective edges 118A, 118B and typically, spectral components to be selected or blocked are incident to the filter aperture plate 118 or the filter aperture 120 at or near the edge 118A or the edge 118B.

The CPB 111B is directed to the lens 112 which produces a chromatically dispersed, focused CPB 116 in which beam portions having different beam spectral components are directed to different locations at the filter aperture plate 118. For purposes of illustration, three spectral beam portions 151-153 are shown but there is generally a continuous distribution of spectral components at the filter aperture plate 118. Chromatic aberration of the lens 112 tends to produce larger beam deflection for lower beam energies so that the spectral beam portion 151 is typically associated with lower beam energies than the spectral beam portion 153.

The CPB optical system 100 also includes a first deflector 122 which serves to provide spectral filtering beam (and referred to in some examples as a beam filtering deflector) and that is situated between the CPB lens 112 and the filter aperture plate 106. A second deflector 124 (referred to in some examples as a beam steering deflector) is situated optically downstream of the filter aperture plate 118 and along the axis 101 at or near a plane 127 that is proximate an axial position at which the axial CPB 111A and the spectrally spread CPB 116 (i.e., portions transmitted through the aperture 120) form the crossover 113. The beam filtering deflector 122 is operable to selectively deflect a spectral component of the CPB 116 so that a beam focus is at or proximate the axis 101. As shown in FIG. 1A, spectral distribution is provided by the lens 112 without deflection by the beam filtering deflector 122. However, the spectrally distributed beam portions can be deflected to permit selection of spectral components otherwise attenuated or blocked by the filter aperture plate 118. In other examples, the filter aperture plate 118 can be moved to permit transmission of a selected spectral component or otherwise positioned with an actuator 119 shown in FIG. 1A as providing translations in an XY-plane of a coordinate system 150 in which a Y-axis extends out of the plane.

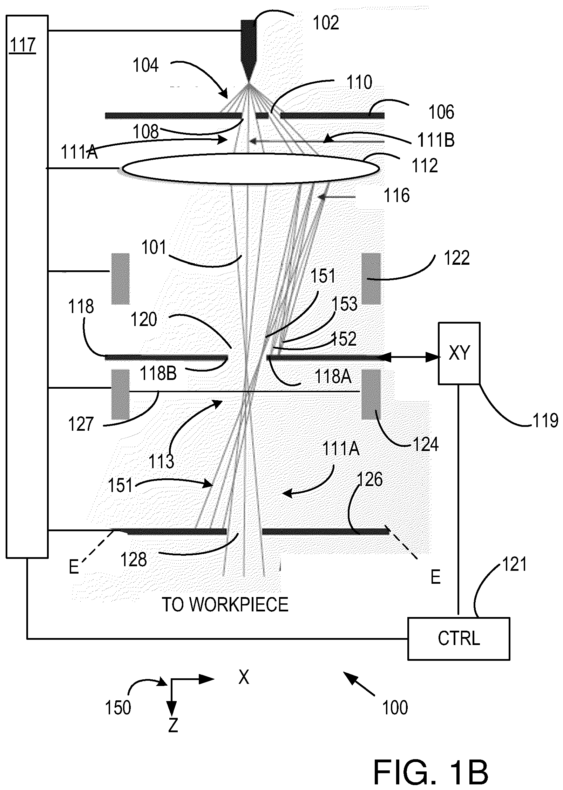

In the example configuration show in FIG. 1A, the CPB spectral beam portion 151 is directed to have a focus on the axis 101 and the spectral beam portions 152, 153 are blocked by the filter aperture plate 118. Without deflection by the beam steering deflector 124, the first CPB 114 propagates through a blanking aperture 128 defined in a blanking aperture plate 126 for delivery to workpiece, a sample, or other target. As shown the beam steering deflector 124 is energized to deflect the axial CPB 111A to be blocked by the blanking aperture plate 126 and the spectral beam portion 151 directed along the axis 101 and through the aperture 128 for delivery to workpiece, sample, or other target. With a suitable deflection applied by beam filtering deflector 122 (or positioning of the filter aperture 120), a selected spectral CPB portion is coupled through the filter aperture 120. The beam steering deflector 124 can be energized to deflect the selected spectral portion along the axis 101 toward the target (shown in FIG. 1A) while without application of deflection, the axial CPB 111A propagates toward the target as shown in FIG. 1B.

In FIGS. 1A-1B, the beam acceptance aperture plate 106 defines two apertures that can be used to produce a central or axial beam and an off-axis or eccentric beam, but additional apertures can be provided having different diameters and situated at different distances from the optical axis 101. The beam acceptance aperture plate 106 is shown situated proximate the CPB source 102 and can serve as an extractor aperture in conjunction with production of the CPB from the CPB source 102. Operating currents and voltages including those used for CPB lenses, beam deflectors, and an optical column generally are provided by one or more sources 117 and can be applied as controlled by a processor system 121 such as a personal computer or other hardware.

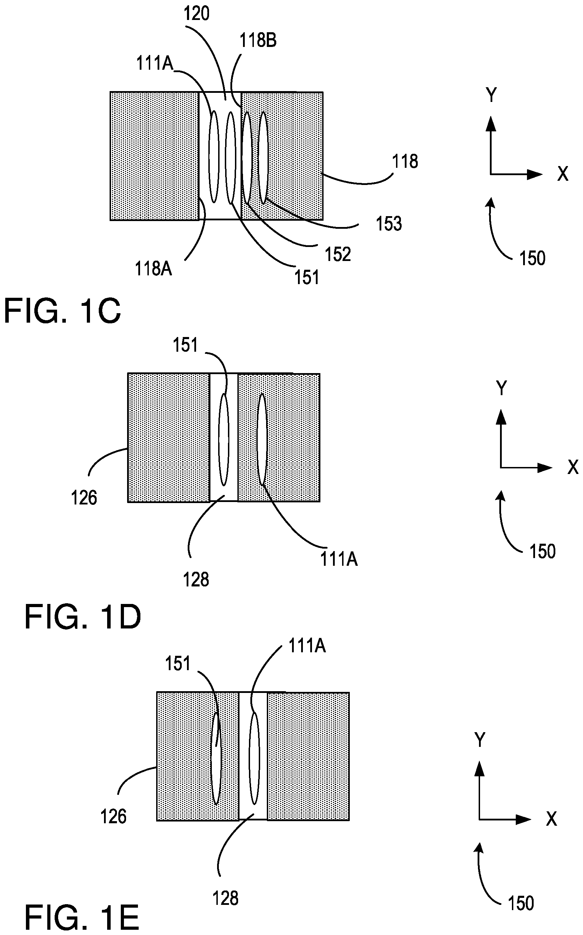

FIG. 1C is schematic sectional view at the filter aperture plate 118 illustrating CPB positions. As shown in FIG. 1C, cross sections of the axial CPB 111A and the spectral beam portions 151-153 are shown as directed toward the filter aperture plate 118. The axial CPB 111A and the spectral beam portion 151 are directed to the filter aperture 120 while the spectral beam portions 152-153 are incident to the filter aperture plate 118 and are blocked. Adjustment of the positions of the spectral beam portions permits selected of a particular spectral beam component. The axial CPB 111A and the spectral beam portion 151 can overlap at the filter aperture 118 but in the example of FIG. 1A, beam overlap is slightly downstream at the plane 127.

FIGS. 1D -1E are schematic sectional views at the blanking aperture plate 126 illustrating CPB positions. As shown in FIG. 1D and corresponding to FIG. 1A, cross sections of the axial CPB 111A and the spectral beam portion 151 are shown as incident toward the blanking aperture plate 126. The spectral beam portion 151 is incident to the blanking aperture 128 and is transmitted. The axial CPB 111A is directed to the blanking aperture plate 126 and is blocked. As shown in FIG. 1E and corresponding to FIG. 1B, cross sections of the axial CPB 111A and the spectral beam portion 151 are shown as directed toward the blanking aperture plate 126. The spectral beam portion 151 is incident to the blanking aperture plate 126 and is blocked. The axial CPB 111A is directed to the blanking aperture 128 and is transmitted. Thus, using the beam steering deflector 124, either the axial CPB 111A or the spectral beam portion 151 can be transmitted to a workpiece.

### Example 2

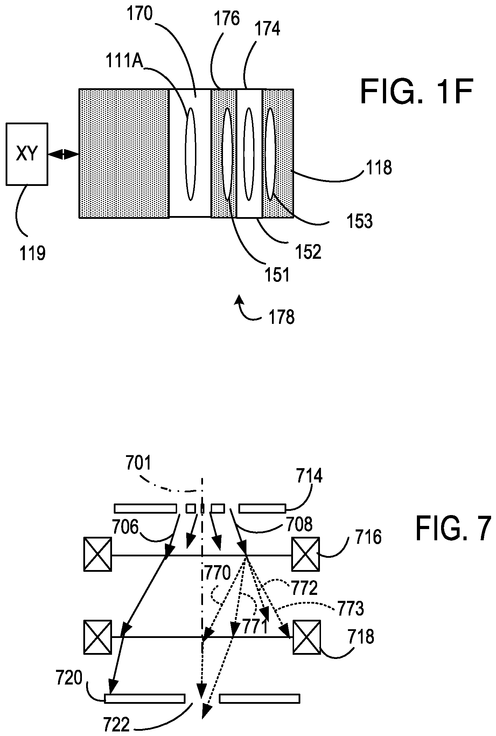

FIG. 1F is a sectional view at a filter aperture plate 178 that can be used as an alternative to the filter aperture plate 118 and illustrates an alternative filtering arrangement for use in the CPB system 100 of FIGS. 1A-1B. The filter aperture plate 178 defines a first aperture 170 and a second aperture 174 separated by a CPB blocking region 176. In this example, the spectral beam portions 151, 153 are blocked and the spectral beam portion 152 is transmitted by the second aperture 174 and the axial CPB 111A is transmitted by the first aperture 170. By adjusting the position of the beam filter aperture plate 168 with the actuator 119 or adjusting beam positions with the beam filtering deflector 122, a selected one of the spectral beam components 151-153 can be transmitted to a workpiece. In other examples, a plurality of apertures in a filter aperture plate can be provided, and one or more selected spectral beam components can be selected.

### Example 3

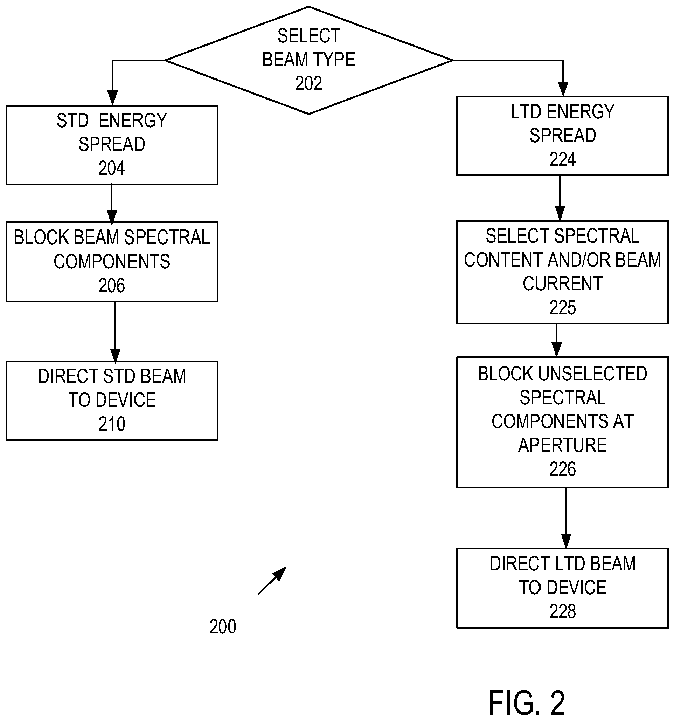

With reference to FIG. 2, a representative method 200 includes selecting a CPB type such a CPB with a higher beam current without spectral filtering or a CPB with a lower beam current with a selected spectral content at 202. In this example, a CPB with a higher beam current without spectral filtering is referred to as having a standard spectral or energy spread (STD). The lower current CPB is referred to as having a limited energy spread (LTD) as it is generally produced by spectral filtering as illustrated above in FIGS. 1A-1B. If a standard energy spread is selected at 204, a first CPB without spectral filtering is transmitted and additional beams having limited spectral content are blocked at a filter aperture and/or at a blanking aperture at 206. A CPB with a STD energy spread is directed toward a workpiece at 210. In the example of FIGS. 1A-1B, beam portions with some spectral contents are blocked by a filter aperture while at least one beam have a selected spectral content is blocked by the blanking aperture. If LTD energy spread is selected at 224, a particular energy spread and beam current can be selected at 225, and unselected spectral components and a CPB with a STD energy spread are blocked or attenuated at 226, and a CPB with an LTD energy spread is directed to the workpiece at 228.

Particular lower current beams and spectral contents (LTD CPBs) can be selected using one or more filter apertures, a blanking aperture, and /one or more beam deflectors such as a beam steering deflector and a beam filtering deflector. A filter aperture can be selected by adjusting beam positions with a beam deflector or moving an associated aperture plate with an actuator and blocking unselected beam portions.

### Example 4

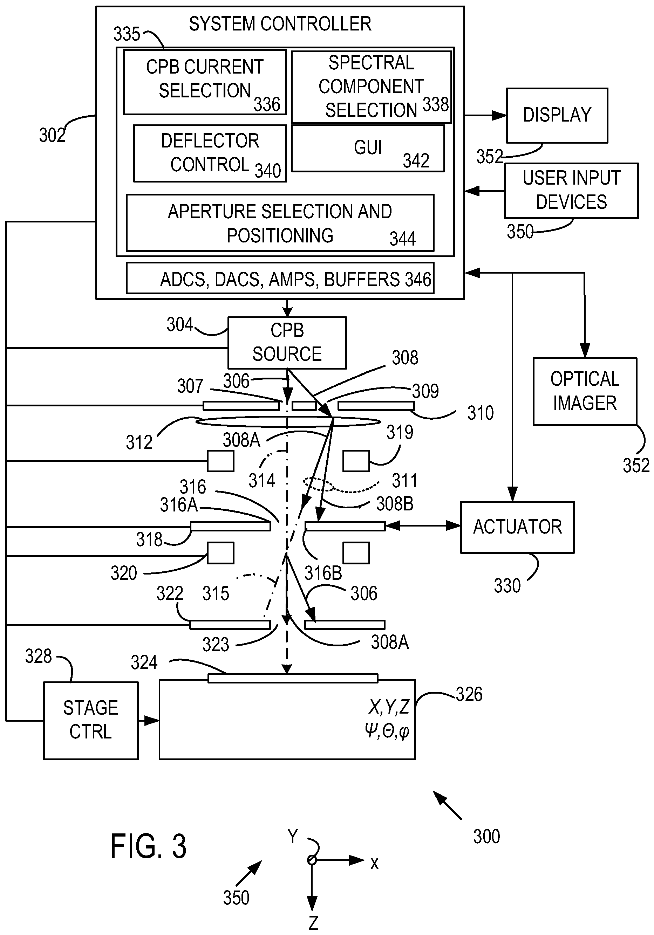

Referring to FIG. 3, a CPB system 300 includes a system controller 302 that is coupled to CPB source 304 that produces an axial CPB 306 and an off-axis CPB 308 that are defined by respective apertures 307, 309 in a beam acceptance aperture plate 310. A lens 312 directs the axial CPB 306 along an axis 314 and spectrally spreads the off-axis CPB 308 over a region 311. The spectral spread is associated with chromatic aberration of the lens 312 for convenience but can be provided with other CPB optical elements. For purposes of illustration, FIG. 3 shows representative first and second spectral component CPBs 308A, 308B that are directed along respective axes, such as an axis 315 associated with the first spectral component CPB 308A. In typical examples, the CPB lens 312 tends to provide greater deflection for less energetic CPBs so that the spectral component CPB 308A has a lower beam energy than that of the spectral beam component 308B.

The spectral component CPBs 308A, 308B and the axial beam 306 are directed towards a filter aperture 316 having first and second edges 316A, 316B as defined in a filter aperture plate 318. As shown, the first spectral component CPB 308A and the axial CPB 306 are transmitted by the filter aperture 316 while the second spectral component CPB 308B is directed to the filter aperture plate 318 and is blocked. A beam filtering deflector 319 can be situated to deflect a selected spectral component CPB to be transmitted by the filter aperture 316. For example, the second spectral component CPB 308B can be deflected to be transmitted, and unselected spectral beam portions such as the spectral component CPB 308A blocked elsewhere. Alternatively, the filter aperture plate 318 can define one or more additional apertures used to select a spectral component. Unselected components can be blocked at the filter aperture plate 318 or elsewhere. In some cases, selection of a particular spectral component is used to select a CPB current and CPB spectrum is of lesser or no concern.

A beam steering deflector 320 is situated to direct either the first component CPB 308A or the axial CPB 306 along the axis 314 or otherwise toward a workpiece. As shown, the axial CPB 306 is deflected to be incident to a blanking aperture plate 322 and the first spectral component CPB 308A is directed through a blanking aperture 323 defined in the blanking aperture plate 322. The beam steering deflector 320 can also be activated to direct the axial beam 306 through the blanking aperture 323 and allow the first spectral component beam 308A to continue along the axis 315 to be incident to the blanking aperture plate 322 and be blocked. It can be advantageous to block the axial CPB 306 at the blanking aperture plate 322 as this beam is typically a high current CPB and can be blocked by the blanking aperture plate 322 without degrading the blanking aperture 320.

A selected CPB is delivered to a workpiece 324 that is situated on a stage 326 that provides translational motion along one, two, or three axes such as X, Y, Z axes of a right-hand Cartesian coordinate system 350 in which a Y-axis extends out of the plane of the drawing and one or more angular rotations such as specified by a polar angle and an azimuthal angle. The stage 326 is responsive to a stage controller 328 that is coupled to the system controller 302. An optical imager 352 can be situated to provide optical images of the workpiece 324.

As discussed above, the beam filtering deflector and the filter aperture plate 318 can be used to select CPB spectral components. In the example of FIG. 3, if a spectral component is selected with an energy less than that of the spectral component CPB 308A, the spectral component CPB 308B and higher energy components can be directed to and blocked by the filter aperture plate 318. If a higher energy component is selected (transmitted) such as the spectral component CPB 308B, a lower energy component such as the spectral component CPB 308A is blocked by aperture edge 316A. One or both of the beam acceptance aperture plate 306 and the filter aperture plate 318 can include multiple apertures to aid in selection of spectral components and/or CPB currents. An actuator 330 can be coupled to the filter aperture plate 318 to adjust positioning of filter aperture edges 316A, 316B to select a spectral component or CPB current, or to compensate for beam-induced degradation.

The system controller 302 is coupled to a memory 335 that stores processor-executable instructions for image processing such as CPB current selection 336, spectral component selection 338, deflector control 340, aperture selection and position 344, and to provide a GUI 342 for various functions. System control parameters can be specified using internally stored values from the memory 335 or provided by a user with one or more user input devices 350. In most examples, interface circuitry 346 such as one or more ADCs, DACs, amplifiers, or buffer amplifiers are included for control of the CPB source 304, the actuator 330 and other parts of the system 302.

It will be appreciated that the layout of FIG. 3 is for convenient illustration, and actual alignments of are not shown. In addition, only a single CPB source and an associated optical column are shown, but in some examples, two or more CPB sources and optical columns are provided such as an ion beam optical column used in workpiece processing and an electron beam optical column used in workpiece imaging.

### Example 5

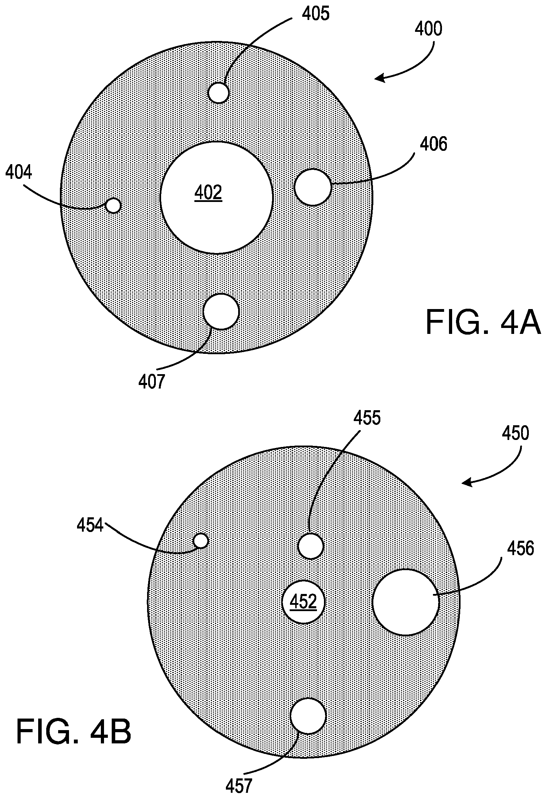

With reference to FIG. 4A, an acceptance aperture plate 400 defines beam acceptance apertures 404-407, each having a different diameter and area and situated at different distances from a central aperture 402. The acceptance aperture plate 400 can be situated to produce CPBs having different beam currents and thus differing levels of Coulomb interaction. Apertures defined in the beam acceptance aperture plate 400 can be distributed radially, azimuthally, or arbitrarily to provide CPB currents and CPBs that are incident to one or more CPB optical elements such as CPB lenses to permit selection of spectral components as well.

With the central aperture 402 aligned with respect to an optical column, the apertures 404-407 define additional CPBs having different beam currents due to their differing areas and differing locations with respect to an axis of a CPB emitter or an axis of an optical column. Differing locations can result in different positions of spectral components as focused by a downstream CPB lens as shown in FIG. 1A. Apertures need not be circular but can have arbitrary shapes which can be the same or different. Multi-aperture plates can also be used to define filter apertures, and CPBs associated with a particular aperture in a multi-aperture plate can be selected with suitable positioning of the aperture plate with a linear and/or rotational actuator, using a CPB deflector, or with both positioning the aperture plate with an actuator and the CPB with a CPB deflector.

With reference to FIG. 4B, an acceptance aperture plate 450 defines beam acceptance apertures 454-457, each having a different diameter and area and situated at different distances from a central aperture 452. In this example, the central acceptance aperture 452 has a smaller diameter than at least one other acceptance aperture and can be used to provide an on-axis beam having a lower beam current than that produced with an off-axis acceptance aperture such as the acceptance aperture 456 and thus differing levels of Coulomb interaction. Apertures defined in the beam acceptance aperture plates 400, 450 are shown as circular but other shapes such as rectangular or other polygonal shapes as well as oval, elliptical, or other shapes can be used. In addition, acceptance aperture plates need not be round.

### Example 6

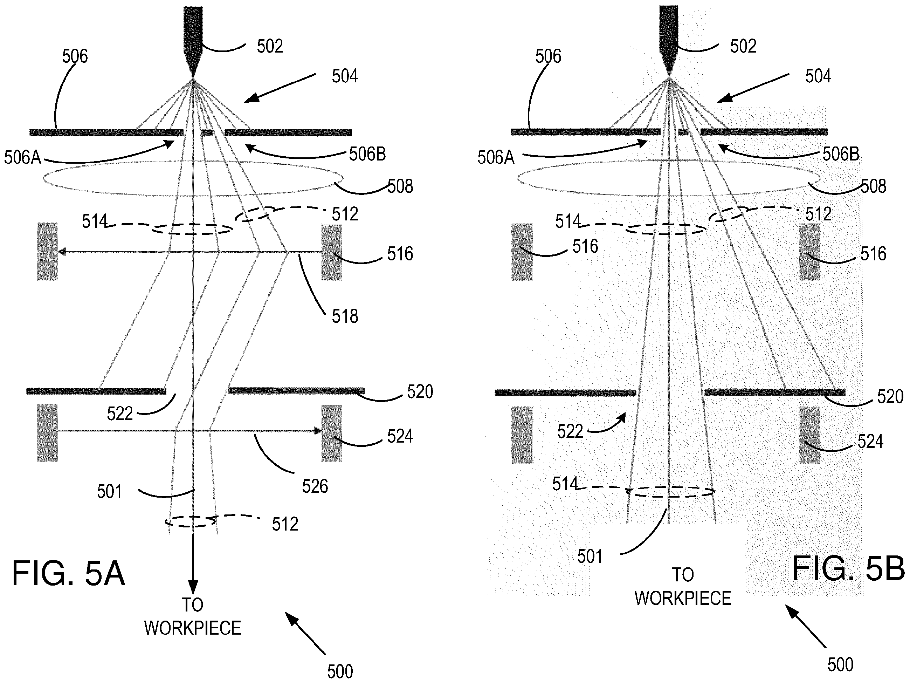

Referring to FIGS. 5A-5B, a CPB system 500 that is operable to provide CPBs with differing CPB currents includes a CPB source 502 that directs a CPB 504 to an acceptance aperture plate 506. The acceptance aperture plate 506 defines a first aperture 506A and second aperture 506B that transmit a first CPB 514 and a second CPB 512. The first CPB 514 and the aperture 506A are in this example situated on an axis 501 and are referred to as an axial or on-axis CPB and an axial or on-axis aperture, respectively. The second CPB 512 and the aperture 506B are not situated on the axis 501 and are referred to as an off-axis CPB and an off-axis aperture, respectively. However, as discussed below, these CPBs can be manipulated to propagate as on-axis or off-axis CPBs in various locations within an optical column depending on applied deflections. The first CPB 514 typically (but not necessarily) has a substantially higher beam current than the second CPB 512 and tends to exhibit greater Coulomb interactions which can, for example, limit beam focusing. A CPB lens 508 is situated on the axis 501 to focus or shape CPBs, but focusing is not shown in FIGS, 5A-5B.

The first CPB 514 and the second CPB 512 are directed along to be deflected by a beam selecting deflector 516 that is shown in FIG. 5A as applying a deflection that directs the first CPB 514 to a blanking aperture plate 520 and the second CPB 512 to an aperture 522 in the blanking aperture plate 520. The applied deflection is shown as occurring at a deflection plane 518 but deflection can be distributed along the axis 501. A second deflector 524 (a beam steering deflector) deflects the selected CPB (i.e., the second CPB 512) and directs the selected CPB to propagate along the axis 501. As a result, the second CPB 512 is directed to a workpiece while the first CPB 514 is blocked.

Referring to FIG. 5B, the beam selecting deflector 516 shown as applying no deflection so that the first CPB 514 propagates along the axis 501 without deflection by the second deflector 524. The second CPB 512 is directed to the blanking aperture plate 520 and is blocked. In this arrangement, the second CPB 512 is blocked and the first CPB 514 is directed to the workpiece along the axis 501. Thus, with the arrangement of FIGS. 5A-5B, either an axial CPB or an off-axis CPB with different currents can be selected and delivered along a common axis (the axis 501) to a workpiece.

### Example 7

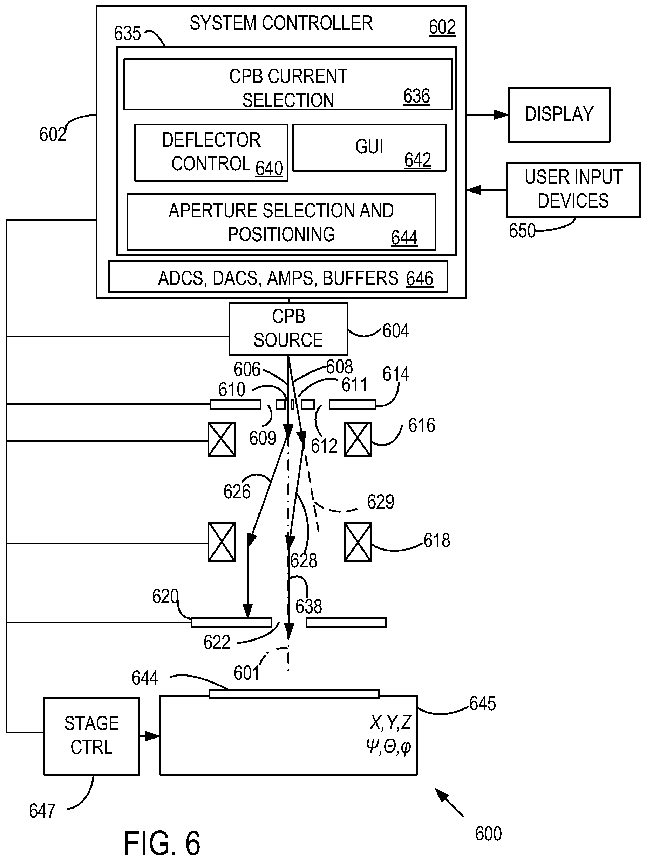

Referring to FIG. 6, a CPB system 600 includes a system controller 602 that is coupled to CPB source 604 that produces an axial CPB 606 and an off-axis CPB 608 that are defined by respective apertures 610, 611 in a beam acceptance aperture plate 614 that can include additional apertures 609, 612 which can be used to define CPBs as well. In some cases, the apertures are sized to provide a desired beam current, and in some examples, the off-axis CPB 608 has a higher beam current than the axial CPB 606. As shown, the axial CPB 606 propagates along an optical axis 601 and the off-axis CPB propagates along an axis 629 established based on locations of the CPB source 604 and the beam acceptance aperture plate 614.

A first beam deflector 616 is operable to deflect the off-axis CPB 608 towards the optical axis 601 as a deflected off-axis CPB 628 and deflect the axial CPB 606 away from the axis 601 as a deflected axial CPB 626. Alternatively, the first beam deflector 616 can be operated to allow the axial CPB 606 to propagate without deflection along the optical axis 601 and the off-axis beam 608 to continue to propagate away from the optical axis 601 along the axis 629. A second deflector 618 is operable to deflect the deflected off-axis CPB 628 to form a working beam 638 that propagates along the optical axis 601 towards a workpiece 644 through a blanking aperture 622 defined in a blanking aperture plate 620. The deflected axial beam 626 is deflected by the second deflector 618 as well towards the optical axis 601 but is blocked at the blanking aperture plate 620. The axial beam 606 and the off-axis beam 608 can have different beam currents. For example, the off-axis beam 608 can have a larger beam current than the axial beam current 606, or vice versa. The system controller 602 is coupled to the first deflector 616 and the second deflector 618 to selectively direct one of the axial CPB 606 and the off-axis CPB 608 to the workpiece 644. In FIG. 6, the axial CPB 606 is delivered to the workpiece 644 with the first deflector 616 and the second deflector 618 operated to provide no beam deflections so that the off-axis beam 608 propagates along the axis 629 and is blocked by the blanking aperture plate 620. In other examples, the deflectors 616, 618 produce deflections that deflect the axial CPB 606 away from the optical axis 601 and then deflect the axial CPB 606 through the blanking aperture 622 to deliver the axial CPB 606 to the workpiece 644. The off-axis CPB 606 can be deflected to propagate along the optical axis 601 and then deflected again to be incident to the blanking aperture plate 620.

As shown, the beam acceptance aperture plate 614 can define multiple apertures, and CPBs based on any of these apertures can be selectively directed to the workpiece 644 while other CPBs are blocked. In this example, the aperture 610 is used to produce an axial CPB and the aperture 611 used to produce an off-axis CPB, but in other examples, both CPBs can be off-axis CPBs. Selection of a particular CPB as a working CPB can be accomplished with the first deflector 616 and the second deflector 618 to block CPBs associated with all but one aperture in the beam acceptance aperture plate 614. In some cases, the beam acceptance aperture plate 614 can be rotated and/or translated with one or more actuators in order to position a selected acceptance aperture with respect to the CPB source 604 to provide an off-axis beam at a particular angle and CPB current.

The system controller 602 is coupled to a memory 635 that stores processor-executable instructions for image processing such as CPB current selection 636, deflector control 640, beam acceptance aperture selection and positioning 644, and to provide a GUI 642 for various functions. System control parameters can be specified using internally stored values from the memory 635 or provided by a user with one or more user input devices 650. In most examples, interface circuitry 646 such as one or more ADCs, DACs, amplifiers, or buffer amplifiers are included for control of the CPB source 604, actuators, and other parts of the system 600. Beam deflectors are shown in FIG. 6 but in other examples, CPB lenses or combinations of lenses and beam deflectors can be used to direct a selected CPB to the workpiece 644. The workpiece 644 can be situated on a stage 645 that is coupled to a stage controller 647 for workpiece positioning in response to the system controller 602.

It will be appreciated that the layout of FIG. 6 is for convenient illustration, and actual alignments of are not shown. In addition, only a single CPB source and an associated optical column are shown, but in some examples, two or more CPB sources and optical columns are provided such as an ion beam optical column used in workpiece processing and an electron beam optical column used in workpiece imaging.

### Example 8

In some examples, CPBs from a plurality of beam acceptance apertures can be selected. Referring to FIG. 7, a beam acceptance aperture plate 714 defines a plurality of beam acceptance apertures that produce corresponding CPBs such as the representative first CPB 706 and the second CPB 708. These CPBs propagate with respect to an optical axis 701 toward a workpiece. A first deflector 716 and a second deflector 718 are situated to select one or more CPBs associated with the corresponding beam acceptance apertures for delivery to a workpiece through a blanking aperture 722 in a blanking aperture plate 720. Representative CPB paths 770-773 are illustrated for the second CPB 708. The beam path 770 is deflected to the optical axis 701 by the first deflector and then along the axis 701 by the second deflector 718 for transmission by the blanking aperture 722. The beam path 771 is associated with deflection toward the optical axis 701 (but not to the optical axis 701) and then through the blanking aperture 722 but not parallel to the optical axis 701 The beam path 772 corresponds to a beam path without deflection by either the first deflector 716 or the second deflector 718. The beam path 773 is results from deflection of another CPB such as the first CPB 706 toward the optical axis 701. Any of the CPBs produced with the beam acceptance aperture plate 722 can be directed to the workpiece while some or all other CPBs are blanked.

### Example 8

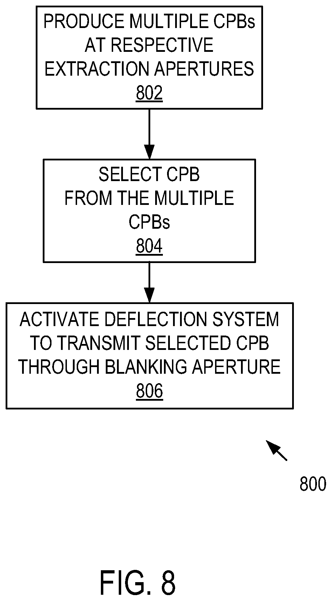

With reference to FIG. 8, a representative method 800 includes producing multiple CPBs with corresponding apertures in an extractor aperture plate at 802. At 804, a particular CPB is selected based on, for example, a desired beam current. At 806, a defection system is activated to direct the selected CPB to a workpiece through a blanking aperture and blocking other CPBs.

### Disclosure Clauses

Clause 1 is a charged-particle beam (CPB) optical system, including: a beam acceptance aperture plate defining a first acceptance aperture and at least one second acceptance aperture and situated with respect to a CPB source so that a first CPB is transmitted by the first acceptance aperture and a second CPB is transmitted by the at least one second acceptance aperture; a CPB lens situated to receive the first CPB and the second CPB from the beam acceptance aperture plate; a filter aperture plate that defines a filter aperture, wherein the CPB lens is operable to direct the first CPB and a selected portion of the second CPB through the filter aperture such that at least the second CPB has an associated spectral spread proximate the filter aperture plate; and a beam steering deflector operable to deflect the first CPB or the selected portion of the second CPB transmitted by the filter aperture to a workpiece.

Clause 2 includes the subject matter of Clauses 1, and further specifies that the first acceptance aperture of the beam acceptance aperture plate is situated on an optical axis defined by the CPB lens.

Clause 3 includes the subject matter of any of Clauses 1-2, and further includes a CPB emitter, wherein the first acceptance aperture of the beam acceptance aperture plate, the CPB lens, and the CPB emitter are situated on an optical axis.

Clause 4 includes the subject matter of any of Clauses 1-3, and further includes a blanking aperture plate that defines a blanking aperture, the blanking aperture situated to transmit the first CPB and attenuate the selected portion of the second CPB received from a beam filtering deflector or transmit the selected portion of the second CPB and attenuate the first CPB received from the beam filtering deflector.

Clause 5 includes the subject matter of any of Clauses 1-4, and further includes a beam selecting deflector operable to selectively direct either the first CPB or a selected portion of the second CPB through the blanking aperture.

Clause 6 includes the subject matter of any of Clauses 1-5, and further specifies that the beam selecting deflector is operable to selectively direct either the first CPB or the selected portion of the second CPB along an optical axis.

Clause 7 includes the subject matter of any of Clauses 1-6, and further includes an actuator coupled to the filter aperture plate and operable to situate the filter aperture plate so that an edge of the filter aperture plate is situated to pass the selected portion of the second CPB.

Clause 8 includes the subject matter of any of Clauses 1-7, and further includes an actuator coupled to the filter aperture plate and operable to situate the filter aperture plate so that an edge of the filter aperture plate is situated so that an unselected portion of the second CPB is blocked by the filter aperture plate.

Clause 9 includes the subject matter of any of Clauses 1-8, and further includes an actuator coupled to the filter aperture plate and operable to situate the filter aperture plate so that an edge of the filter aperture plate is situated so that an unselected portion of the second CPB is blocked by the filter aperture plate.

Clause 10 includes the subject matter of any of Clauses 1-9, and further includes a control system coupled to the actuator and operable to move the filter aperture plate to allow the selected portion of the second CPB to pass through the filter aperture.

Clause 11 includes the subject matter of any of Clauses 1-10, and further specifies that the at least one second acceptance aperture includes a plurality of secondary acceptance apertures situated to define respective secondary CPBs that are directed toward the filter aperture plate so that the filter aperture transmits at least one of the secondary CPBs, and further includes a beam selecting deflector situated to direct either the first CPB or the selected one of the secondary CPBs along an optical axis.

Clause 12 is a method, including: producing at least a first CPB and a second CPB propagating along a first axis and a second axis, respectively, wherein the first axis is different from the second axis; with a charged-particle-beam lens, directing the second CPB towards the first axis and towards a filter aperture so that spectral components of the second CPB are distributed at the filter aperture; at the filter aperture, selectively transmitting at least a selected spectral component of the second CPB; and directing either the first CPB or the selected spectral component of the second CPB along the first axis.

Clause 13 includes the subject matter of Clause 12, and further includes directing the selected spectral component of the second CPB along the first axis with a beam selecting deflector.

Clause 14 includes the subject matter of any of Clauses 12-13, and further specifies that the distribution of spectral components of second CPB at the filter aperture is based on chromatic aberration of a CPB lens.

Clause 15 includes the subject matter of any of Clauses 12-14, and further includes selectively attenuating either the first CPB or the spectral component of the second CPB at a blanking aperture plate and transmitting either the spectral component of the second CPB or the first CPB through a blanking aperture defined in the blanking aperture plate.

Clause 16 includes the subject matter of any of Clauses 12-15, and further includes situating an edge of the blanking aperture so that the selected spectral component of the second CPB is transmitted through the blanking aperture and unselected spectral components are attenuated.

Clause 17 includes the subject matter of any of Clauses 12-16, and further specifies that the first axis is an optical axis.

Clause 18 includes the subject matter of any of Clauses 12-17, and further specifies that the first CPB and the second CPB are produced by directing at least one CPB to a beam acceptance aperture plate defining a first aperture and a second aperture, wherein the first aperture is situated on an optical axis.

Clause 19 is a method, including: producing at least a first CPB and a second CPB propagating along a first axis and a second axis, respectively, wherein the first axis is different from the second axis; directing the second CPB towards the first axis and towards a filter aperture so that spectral components of the second CPB are distributed at the filter aperture; at the filter aperture, selectively transmitting at least a selected spectral component of the second CPB; and directing either the first CPB or the selected spectral component of the second CPB toward a workpiece.

Clause 20 includes the subject matter of Clause 19, and further includes the directing either the first CPB or the selected spectral component of the second CPB toward a workpiece along the first axis.

Clause 21 includes the subject matter of any of Clauses 19-20, and further includes attenuating unselected spectral components of the second CPB at an aperture plate situated to transmit the select spectral component, and selectively directing one of the first CPB and the selected spectral component of the second CPB through a blanking aperture and attenuating the selected spectral component of the second CPB or the first CPB, respectively, at the blanking aperture.

Clause 22 is a charged-particle beam (CPB) optical system, including: a beam acceptance aperture plate defining a first acceptance aperture and at least one second acceptance aperture and situated with respect to a CPB source so that a first CPB is transmitted by the first acceptance aperture and a second CPB is transmitted by the at least one second acceptance aperture; a blanking aperture plate defining a blanking aperture; and a beam selector operable to selectively direct the first CPB or the second CPB to a workpiece through the blanking aperture.

Clause 23 includes the subject matter of any of Clauses 22, and further includes an optical column situated to receive the first CPB and the second CPB, wherein the first acceptance aperture or a selected second acceptance aperture is situated on an optical axis of the optical column.

Clause 24 includes the subject matter of any of Clauses 22-23, and further specifies that the beam selector includes a first beam deflector and a second beam deflector, the first beam deflector operable to deflect the second CPB toward an optical axis and the second beam deflector operable to direct the second CPB received from the first beam deflector to a workpiece through the blanking aperture.

Clause 25 includes the subject matter of any of Clauses 22-24, and further specifies that the first acceptance aperture and the second acceptance aperture are off-axis apertures.

Clause 26 includes the subject matter of any of Clauses 22-25, where the first acceptance aperture is an on-axis aperture and the second acceptance aperture is an off-axis aperture.

Clause 27 includes the subject matter of any of Clauses 22-26, and further specifies that a beam current associated with the second acceptance aperture is larger than a beam current associated with the first acceptance aperture.

Clause 28 includes the subject matter of any of Clauses 22-27, and further specifies that the beam acceptance aperture plate defines the first acceptance aperture, the second acceptance aperture, and a third acceptance aperture, the third acceptance aperture transmitting a third CPB, wherein the beam selector is operable to selectively direct the second CPB and the third CPB to the workpiece through the blanking aperture.

Clause 29 includes the subject matter of any of Clauses 22-28, and further specifies that the beam selector includes at least one beam deflector or at least one CPB lens.

Clause 30 includes the subject matter of any of Clauses 22-29, and further includes: a spectral disperser situated to receive the first CPB and the second CPB from the beam acceptance aperture plate and spectrally disperse at least one of the first CPB and the second CPB; and a filter aperture plate that defines a filter aperture, wherein the spectral disperser is operable direct the first CPB and a selected portion of the second CPB through the filter aperture such that at least the second CPB has an associated spectral spread proximate the filter aperture plate, wherein the beam selector is operable to deflect the first CPB or the selected portion of the second CPB transmitted by the filter aperture to a workpiece.

Clause 31 includes the subject matter of any of Clauses 22-30, and further specifies that the spectral disperser includes a CPB lens operable to spectrally disperse at least one of the first CPB and the second CPB based on chromatic aberration.

Clause 32 includes the subject matter of any of Clauses 22-31, and further includes a CPB emitter, wherein the first acceptance aperture of the beam acceptance aperture plate, the CPB lens, and the CPB emitter are situated on an optical axis.

Clause 33 includes the subject matter of any of Clauses 22-32, and further includes an actuator coupled to the filter aperture plate and operable to situate the filter aperture plate so that an edge of the filter aperture plate is situated to pass the selected portion of the second CPB.

Clause 34 includes the subject matter of any of Clauses 22-33, and further includes an actuator coupled to the filter aperture plate and operable to situate the filter aperture plate so that an edge of the filter aperture plate is situated so that an unselected portion of the second CPB is blocked by the filter aperture plate.

Clause 35 includes the subject matter of any of Clauses 22-34, and further includes a control system coupled to the actuator and operable to move the filter aperture plate to allow the selected portion of the second CPB to pass through the filter aperture.

Clause 36 is a method, including: producing at least a first CPB and a second CPB propagating along a first axis and a second axis, respectively, wherein the first axis is different from the second axis; with a charged-particle-beam lens, directing the second CPB towards the first axis and towards a filter aperture so that spectral components of the second CPB are distributed at the filter aperture; at the filter aperture, selectively transmitting at least a selected spectral component of the second CPB; and directing either the first CPB or the selected spectral component of the second CPB along the first axis.

Clause 37 includes the subject matter Clause 36, and further includes directing the selected spectral component of the second CPB along the first axis with a beam selecting deflector.

Clause 38 includes the subject matter of any of Clauses 36-37, and further specifies that the distribution of spectral components of the second CPB at the filter aperture is based on chromatic aberration of a CPB lens.

Clause 39 includes the subject matter of any of Clauses 36-38, and further includes selectively attenuating either the first CPB or the spectral component of the second CPB at a blanking aperture plate and transmitting either the spectral component of the second CPB or the first CPB through a blanking aperture defined in the blanking aperture plate.

Clause 40 includes the subject matter of any of Clauses 36-39, and further includes situating an edge of the blanking aperture so that the selected spectral component of the second CPB is transmitted through the blanking aperture and unselected spectral components are attenuated.

Clause 41 includes the subject matter of any of Clauses 36-40, and further specifies that the first axis is an optical axis.

Clause 42 includes the subject matter of any of Clauses 36-41, and further specifies that the first CPB and the second CPB are produced by directing at least one CPB to a beam acceptance aperture plate defining a first aperture and a second aperture, wherein the first aperture is situated on an optical axis.

Clause 43 is a method, including: producing at least a first CPB and a second CPB propagating along a first axis and a second axis, respectively, wherein the first axis is different from the second axis; selectively directing the second CPB towards the first axis; and at a blanking aperture plate, transmitting the second CPB towards a workpiece and attenuating the first CPB.

Clause 44 includes the subject matter of Clause 43, and further specifies that the second CPB is selectively directed towards the first axis by a first beam selector and directed along the first axis by a second beam selector.

In view of the many possible embodiments to which the principles of the disclosed technology may be applied, it should be recognized that the illustrated embodiments are only preferred examples should not be taken as limiting the scope of the disclosure.

## Claims

1. A charged-particle beam (CPB) optical system, comprising:
a beam acceptance aperture plate defining a first acceptance aperture and at least one second acceptance aperture and situated with respect to a CPB source so that a first CPB is transmitted by the first acceptance aperture and a second CPB is transmitted by the at least one second acceptance aperture;
a blanking aperture plate defining a blanking aperture; and
a beam selector operable to selectively direct the first CPB or the second CPB to a workpiece through the blanking aperture.

2. The CPB optical system of claim 1, further comprising an optical column situated to receive the first CPB and the second CPB, wherein the first acceptance aperture or a selected second acceptance aperture is situated on an optical axis of the optical column.

3. The CPB system of claim 1, wherein the beam selector includes a first beam deflector and a second beam deflector, the first beam deflector operable to deflect the second CPB toward an optical axis and the second beam deflector operable to direct the second CPB received from the first beam deflector to a workpiece through the blanking aperture.

4. The CPB system of claim 3, wherein the first acceptance aperture and the second acceptance aperture are off-axis apertures.

5. The CPB system of claim 3, where the first acceptance aperture is an on-axis aperture and the second acceptance aperture is an off-axis aperture.

6. The CPB system of claim 5, wherein a beam current associated with the second acceptance aperture is larger than a beam current associated with the first acceptance aperture.

7. The CPB system of claim 1, wherein the beam acceptance aperture plate defines the first acceptance aperture, the second acceptance aperture, and a third acceptance aperture, the third acceptance aperture transmitting a third CPB, wherein the beam selector is operable to selectively direct the second CPB and the third CPB to the workpiece through the blanking aperture.

8. The CPB system of claim 1, wherein the beam selector includes at least one beam deflector or at least one CPB lens.

9. The CPB optical system of claim 1, further comprising:
a spectral disperser situated to receive the first CPB and the second CPB from the beam acceptance aperture plate and spectrally disperse at least one of the first CPB and the second CPB; and
a filter aperture plate that defines a filter aperture, wherein the spectral disperser is operable direct the first CPB and a selected portion of the second CPB through the filter aperture such that at least the second CPB has an associated spectral spread proximate the filter aperture plate, wherein the beam selector is operable to deflect the first CPB or the selected portion of the second CPB transmitted by the filter aperture to a workpiece.

10. The CPB optical system of claim 9, wherein the spectral disperser includes a CPB lens operable to spectrally disperse at least one of the first CPB and the second CPB based on chromatic aberration.

11. The CPB optical system of claim 10, further comprising a CPB emitter,
wherein the first acceptance aperture of the beam acceptance aperture plate, the CPB lens, and the CPB emitter are situated on an optical axis.

12. The CPB optical system of claim 11, further comprising an actuator coupled to the filter aperture plate and operable to situate the filter aperture plate so that an edge of the filter aperture plate is situated to pass the selected portion of the second CPB.

13. The CPB optical system of claim 11, further comprising an actuator coupled to the filter aperture plate and operable to situate the filter aperture plate so that an edge of the filter aperture plate is situated so that an unselected portion of the second CPB is blocked by the filter aperture plate.

14. The CPB optical system of claim 12, further comprising a control system coupled to the actuator and operable to move the filter aperture plate to allow the selected portion of the second CPB to pass through the filter aperture.

15. A method, comprising:
producing at least a first CPB and a second CPB propagating along a first axis and a second axis, respectively, wherein the first axis is different from the second axis;
selectively directing the second CPB towards the first axis; and
at a blanking aperture plate, transmitting the second CPB towards a workpiece and attenuating the first CPB.

16. The method of claim 22, wherein the second CPB is selectively directed towards the first axis by a first beam selector and directed along the first axis by a second beam selector.
